# EUROPEAN PATENT APPLICATION

(11) **EP 4 645 042 A1**
(43) Date of publication of application: **05.11.2025**
(21) Application number: 25172469.6
(22) Date of filing: 25.04.2025
(51) Int. Cl.: G06F 3/041, G06F 3/044, H10K 59/40

(54) **DISPLAY DEVICE**

(30) Priority: 29.04.2024 KR 20240057033
(71) Applicant: Samsung Display Co., Ltd., Yongin-si, Gyeonggi-do 17113 (KR)
(72) Inventor: Li, Xinxing, 17113 Yongin-si, Gyeonggi-do (KR); Koo, Ji Yun, 17113 Yongin-si, Gyeonggi-do (KR); Kim, Sun Young, 17113 Yongin-si, Gyeonggi-do (KR); Yu, Sun Mi, 17113 Yongin-si, Gyeonggi-do (KR); Choi, Byung Hee, 17113 Yongin-si, Gyeonggi-do (KR); Hyung, Jun Woo, 17113 Yongin-si, Gyeonggi-do (KR)
(74) Representative: Gulde & Partner

(57) **Abstract**

A display device includes a display panel including a plurality of sub-pixels including emission areas, and a touch electrode formed on the display panel and overlapping a non-emission area adjacent to the emission areas. The touch electrode includes a first recess that is recessed in a first direction facing the display panel and overlaps a portion of the non-emission area disposed between first and second emission areas adjacent to each other among the emission areas.

## Description

### TECHNICAL FIELD

The present disclosure relates to a display device.

### DISCUSSION OF THE RELATED ART

Display devices have become an important element of modern electronic devices as they permit the effective and intuitive display of information to a user. Display devices may incorporate touch sensing elements so that a touch may be sensed thereby providing the user with an intuitive means of input. Some display devices suffer from color shift at off-center angles thereby reducing perceived image quality. As image quality is an important asset for display devices, display devices having improved viewing angles are being developed.

### SUMMARY

A display device includes a display panel including a plurality of sub-pixels having emission areas, and a touch electrode formed on the display panel and overlapping a non-emission area adjacent to the emission areas. The touch electrode includes a first recess that is recessed in a first direction facing the display panel and overlapping a portion of the non-emission area disposed between first and second emission areas that are adjacent to each other among the emission areas.

The plurality of sub-pixels may include a first sub-pixel including the first emission area, a second sub-pixel including the second emission area, and a third sub-pixel including a third emission area adjacent to at least one of the first and second emission areas. The second emission area may be greater in size than the first emission area. The third emission area may be greater in size than the second emission area.

The plurality of sub-pixels may further include a fourth sub-pixel including a fourth emission area adjacent to the second emission area among the emission areas. The second emission may be disposed between the first emission area and the fourth emission area. The fourth emission area may have substantially the same size as the first emission area. The touch electrode may further include a second recess overlapping another portion of the non-emission area disposed between the second and fourth emission areas.

The first emission area, the second emission area, and the fourth emission area may be sequentially arranged in a second direction crossing the first direction, and a width of the first recess in a third direction crossing the first and second directions may be different from a width of the second recess in the third direction.

The display device may further include a first insulating layer disposed between the display panel and the touch electrode. The first insulating layer may include a trench that is recessed in the first direction. The first recess may be disposed on the trench.

The first insulating layer may include an organic material.

The touch electrode may be formed by chemical vapor deposition (CVD) on the first insulating layer.

The trench may be formed by removing a portion of the first insulating layer using a photolithography method.

A depth of the trench may be less than a thickness of the first insulating layer.

A thickness of the touch electrode may be less than the depth of the trench.

The display device may further include a first insulating layer disposed between the display panel and the touch electrode. The first insulating layer may include a first through hole overlapping the first recess, and at least a portion of the first recess may be disposed in the first through hole.

The display device may further include a second insulating layer disposed on a portion of an upper surface of the display panel exposed by the first through hole and the first insulating layer.

A portion of the first recess may be disposed on a portion of the second insulating layer overlapping the first through hole.

The portion of the first recess may be lower than the uppermost surface of the second insulating layer disposed on the first insulating layer.

The display device may further include a third insulating layer disposed between the display panel and the first insulating layer. The first through hole may expose a portion of the third insulating layer. A portion of the first recess may be disposed on the portion of the third insulating layer exposed by the first through hole.

The portion of the first recess may be lower than the uppermost surface of the first insulating layer disposed on the third insulating layer.

A method of manufacturing a display device includes forming a pixel circuit layer on a substrate. The pixel circuit layer includes a plurality of pixel circuits. A light emitting element layer is formed on the pixel circuit layer. The light emitting element layer includes a plurality of light emitting elements electrically connected to the plurality of pixel circuits. A thin film encapsulation layer covers the plurality of light emitting elements. A first insulating layer is formed on the thin film encapsulation layer. A trench is formed by removing a portion of the first insulating layer. A touch electrode is formed on the first insulating layer. Tn forming the touch electrode, a portion of the touch electrode is formed as a recess received in the trench. The recess overlaps an area between first and second light emitting elements among the plurality of light emitting elements.

Forming the trench may include forming a through hole exposing a portion of the thin film encapsulation layer by removing the portion of the first insulating layer, and forming a second insulating layer on the first insulating layer and the portion of the thin film encapsulation layer exposed by the through hole. The trench may be defined by a portion of the second insulating layer overlapping the through hole. The touch electrode may be formed on the second insulating layer.

The method may further include forming a second insulating layer on the thin film encapsulation layer, before forming the first insulating layer. The first insulating layer may be formed on the second insulating layer disposed on the thin film encapsulation layer. Forming the trench may include forming a through hole exposing a portion of the second insulating layer by removing the portion of the first insulating layer. The touch electrode may be formed on the first insulating layer and the portion of the second insulating layer exposed by the through hole.

An electronic device includes a processor configured to provide input image data to a display device. A display device is configured to display an image based on the input image data. The display device includes a display panel including a plurality of sub-pixels having emission areas. A touch electrode is formed on the display panel and overlapps a non-emission area adjacent to the emission areas. The touch electrode includes a recess that is recessed in a first direction facing the display panel and overlaps a portion of the non-emission area disposed between first and second emission areas adjacent to each other among the emission areas.

### BRIEF DESCRIPTION OF THE DRAWINGS

The above and other features of the disclosure will become more apparent by describing in further detail embodiments thereof with reference to the accompanying drawings, in which:
FIG. 1 is a schematic block diagram illustrating a display device according to an embodiment of the present disclosure;
FIGS. 2 and 3 are schematic plan views illustrating a display device according to an embodiment of the present disclosure;
FIG. 4 is a schematic cross-sectional view illustrating a stack structure of a display device according to an embodiment of the present disclosure;
FIG. 5 is a cross-sectional view illustrating a stack structure of a display panel according to an embodiment of the present disclosure;
FIG. 6 is a schematic cross-sectional view illustrating a stack structure of a touch sensing unit according to an embodiment of the present disclosure;
FIG. 7 is a schematic cross-sectional view illustrating a stack structure of a touch sensing unit according to an embodiment of the present disclosure;
FIG. 8 is an enlarged plan view of an area AA of FIG. 2 illustrating a structure of touch electrodes according to an embodiment of the present disclosure;
FIG. 9 is a cross-sectional view taken along portion A-A' of FIG. 8;
FIG. 10 is a cross-sectional view taken along portion B-B' of FIG. 8;
FIG. 11 is a cross-sectional view taken along portion C-C'-C" of FIG. 8;
FIG. 12 is a cross-sectional view illustrating a touch sensing unit according to an embodiment of the present disclosure, and is a modified example illustrated by taken portion C-C' of FIG. 8;
FIG. 13 is a cross-sectional view illustrating a touch sensing unit according to an embodiment of the present disclosure, and is a modified example illustrated by taken portion C-C' of FIG. 8;
FIGS. 14A to 14D are cross-sectional views illustrating a method of manufacturing the touch sensing unit shown in FIG. 11;
FIGS. 15A to 15E are cross-sectional views illustrating a method of manufacturing the touch sensing unit shown in FIG. 12;
FIGS. 16A to 16E are cross-sectional views illustrating a method of manufacturing the touch sensing unit shown in FIG. 13;
FIG. 17 is a block diagram illustrating an electronic device including a display device according to embodiments of the present disclosure;
FIG. 18 is a perspective view illustrating an example in which the electronic device Fig. 17 is implemented as a smartphone; and
FIG. 19 is a perspective view illustrating an example in which the electronic device of FIG. 17 is implemented as a tablet personal computer (PC).

### DETAILED DESCRIPTION OF THE EMBODIMENT

Hereinafter, embodiments of the present disclosure are described in detail with reference to the accompanying drawings. In addition, the disclosure may be embodied in other forms without necessarily being limited to the embodiment described herein.

Throughout the specification, in a case where a portion is "connected" to another portion, the case includes not only a case where the portion is "directly connected" but also a case where the portion is "indirectly connected" with another component interposed therebetween. Terms used herein are for describing a specific embodiment and are not necessarily intended to limit other embodiments of the disclosure. In addition, in a case where a certain portion "includes", the case means that the portion may further include another component without excluding another component unless otherwise stated. Here, "and/or" includes all combinations of one or more of corresponding configurations.

Here, terms such as first and second may be used to describe various components, and may be used to distinguish such a component from another component. Therefore, a first component may refer to a second component within a range without departing from the scope disclosed herein.

Spatially relative terms such as "under", "on", and the like may be used for descriptive purposes, thereby describing a relationship between one element or feature and another element(s) or feature(s) as shown in the drawings. Spatially relative terms are intended to include other directions in use, in operation, and/or in manufacturing, in addition to the direction depicted in the drawings. For example, when a device shown in the drawing is turned upside down, elements depicted as being positioned "under" other elements or features are positioned in a direction "on" the other elements or features. Therefore, in an embodiment of the present disclosure, the term "under" may include both directions of on and under. In addition, the device may face in other directions (for example, rotated 90 degrees or in other directions) and thus the spatially relative terms used herein are interpreted according thereto.

Various embodiments are described with reference to drawings schematically illustrating ideal embodiments. Accordingly, shapes may vary from what is shown, for example, according to tolerances and/or manufacturing techniques. While each drawing may represent one or more particular embodiments of the present disclosure, drawn to scale, such that the relative lengths, thicknesses, and angles can be inferred therefrom, it is to be understood that the present invention is not necessarily limited to the relative lengths, thicknesses, and angles shown. Changes to these values may be made within the spirit and scope of the present disclosure, for example, to allow for manufacturing limitations and the like.

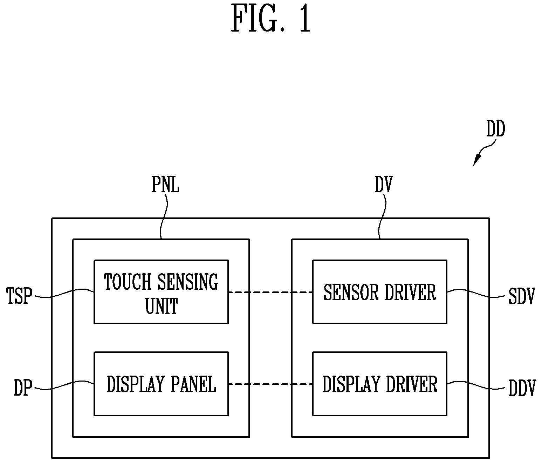

With reference to FIGS. 1 to 3, a display device DD including a display panel DP and a touch sensing unit TSP is described.

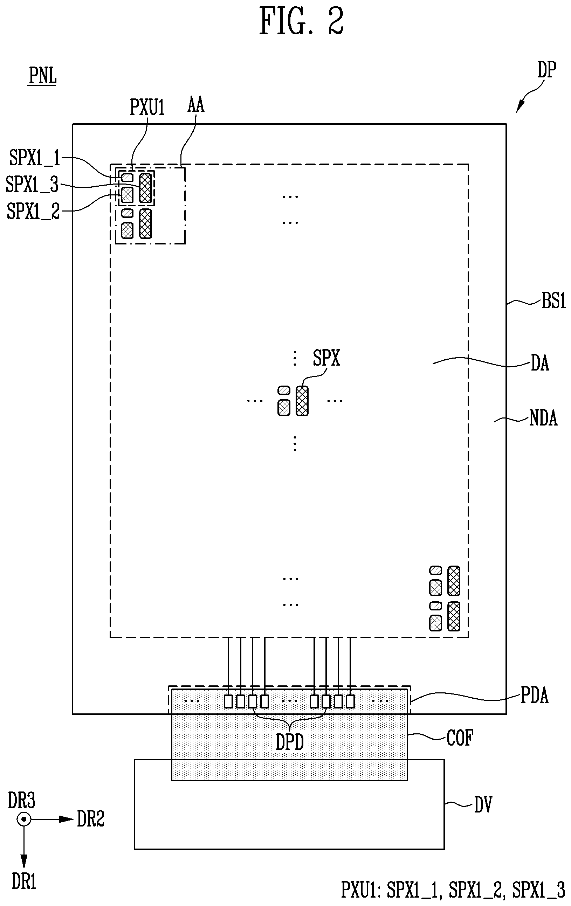

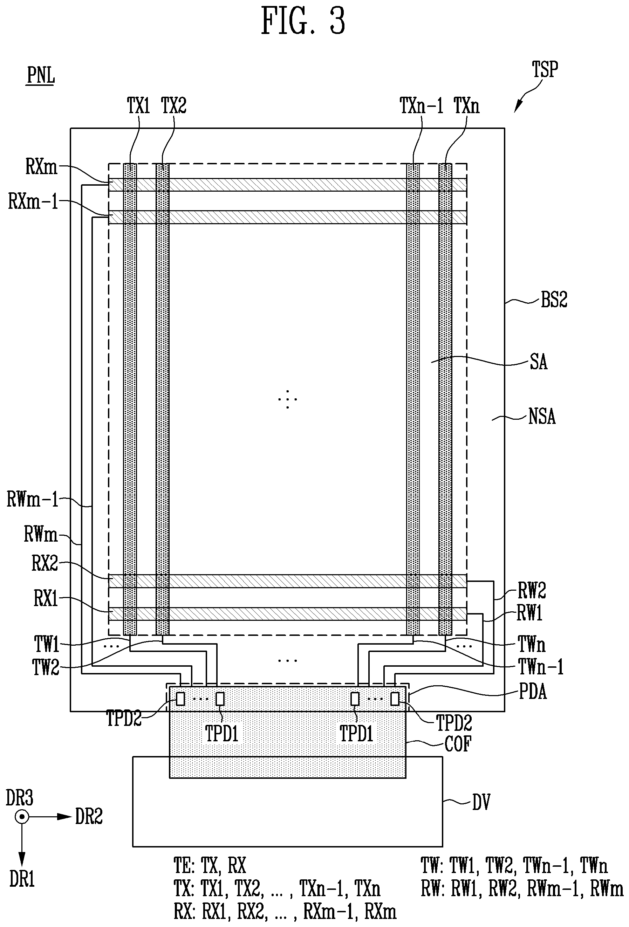

FIG. 1 is a schematic block diagram illustrating a display device according to an embodiment of the present disclosure. FIGS. 2 and 3 are schematic plan views illustrating a display device according to an embodiment of the present disclosure. For example, FIG. 2 may schematically show the display panel DP and a display driver DDV of the display device DD according to an embodiment of the present disclosure. FIG. 3 may schematically show the touch sensing unit TSP and a sensor driver SDV of the display device DD according to an embodiment of the present disclosure.

Referring to FIG. 1, the display device DD may be configured to provide (or emit) light. To this end, the display device DD may include a panel PNL and a driving circuit unit DV for driving the panel PNL.

The panel PNL may include the display panel DP configured to display an image and the touch sensing unit TSP configured to sense a user input (for example, a touch input).

The driving circuit unit DV may include the display driver DDV configured to drive the display panel DP and the sensor driver SDV configured to drive the touch sensing unit TSP.

The display panel DP may display an image in a display frame period unit. The touch sensing unit TSP may sense a user's input (for example, the touch input) in a sensing frame period unit.

According to an embodiment of the present disclosure, a sensing frame period and a display frame period may be independent from each other or may be different from each other. The sensing frame period and the display frame period may be synchronized with each other or may be asynchronized.

The touch sensing unit TSP may be referred to as a touch sensing panel or a touch sensor. The panel PNL may therefore combine the image display properties of the display panel DP with the touch-sensing properties of the touch sensing unit TSP.

Referring to FIG. 2, the display panel DP may include a first base layer BS1 and sub-pixels SPX disposed on the first base layer BS1. The sub-pixels SPX may be disposed in a display area DA. The first base layer BS1 may be a display base layer.

The display panel DP may include the display area DA where an image is displayed and a non-display area NDA in which no image is displayed. According to an embodiment of the present disclosure, the display area DA may be disposed in a central area of the display panel DP, and the non-display area NDA may be disposed adjacent to the display area DA, for example, in a periphery of the display panel DP.

The first base layer BS1 may be a base substrate or a base member for supporting the display device DD. The first base layer BS1 may be a rigid substrate including a glass material. Alternatively, the first base layer BS1 may be a flexible substrate capable of bending, folding, rolling, or the like, to a noticeable extent without cracking or otherwise sustaining damage. In this case, the first base layer BS1 may include an insulating material such as a polymer resin such as polyimide. However, the disclosure is not necessarily particularly limited thereto.

The sub-pixels SPX and scan lines and data lines electrically connected to the sub-pixels SPX may be disposed in the display area DA.

The sub-pixels SPX may be configured to receive a data signal from the data lines based on a turn-on level of scan signal supplied from the scan lines, and emit light with a luminance corresponding to the data signal. Accordingly, an image corresponding to the data signal may be displayed in the display area DA.

The sub-pixels SPX may be arranged according to an arrangement structure in the display area DA. For example, the sub-pixels SPX may be arranged according to a stripe (for example, S-stripe) or PENTILE^{™} arrangement structure, where PENTILE^{™} is an arrangement of luminous areas manufactured by SAMSUNG. However, the disclosure is not necessarily limited to the examples described above.

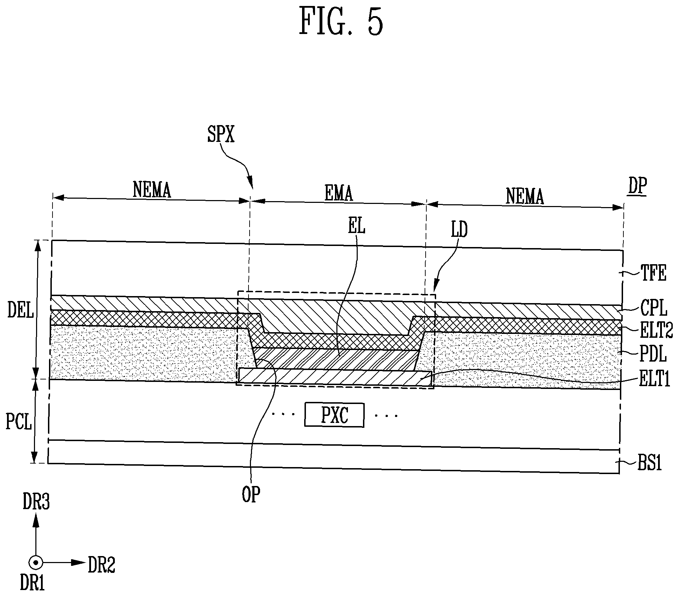

Each of the sub-pixels SPX may include a light emitting element LD (refer to FIG. 5) and a pixel circuit PXC (refer to FIG. 5) for driving the light emitting element LD. The light emitting elements LD included in the sub-pixels SPX are shown. However, embodiments are not necessarily limited to this particular arrangement.

The sub-pixels SPX may include a (1_1)-th sub-pixel SPX1_1, a (1_2)-th sub-pixel SPX1_2, and a (1_3)-th sub-pixel SPX1_3. At least one (1_1)-th sub-pixel SPX1_1, (1_2)-th sub-pixel SPX1_2, and (1_3)-th sub-pixel SPX1_3 may form one first pixel unit PXU1 capable of emitting light of various colors.

For example, each of the (1_1)-th sub-pixel SPX1_1, the (1_2)-th sub-pixel SPX1_2, and the (1_3)-th sub-pixel SPX1_3 may emit light of one color. For example, the (1_1)-th sub-pixel SPX1_1 may be a red pixel emitting red light (for example, a first color), the (1_2)-th sub-pixel SPX1_2 may be a green pixel emitting green light (for example, a second color), and the (1_3)-th sub-pixel SPX1_3 may be a blue pixel emitting blue light (for example, a third color).

Various lines and/or built-in circuit units connected to the sub-pixels SPX of the display area DA may be disposed in the non-display area NDA. For example, a plurality of lines for supplying various power and control signals to the display area DA may be disposed in the non-display area NDA.

The panel PNL may include a pad area PDA. The panel PNL may include display pads DPD, a chip on film COF, and a driving circuit unit DV.

The display pads DPD may be disposed in the pad area PDA. The pad area PDA may be disposed in the non-display area NDA. The non-display area NDA may include the pad area PDA. For example, the pad area PDA may be disposed on one side of the display area DA.

The display pads DPD may be electrically connected to the sub-pixels SPX in the display area DA through lines. The display pads DPD may be electrically connected to the display driver DDV included in the driving circuit unit DV through the chip on film COF. For example, an electrical signal provided by the display driver DDV may be applied to the sub-pixels SPX through the display pads DPD.

The chip on film COF may be electrically connected to the display pads DPD and the display driver DDV. For example, one end of the chip on film COF may be connected to (or attached to) the pad area PDA, and another end of the chip on film COF may be connected to (or attached to) the driving circuit unit DV. At least a portion of the chip on film COF may be bent.

The chip on film COF may include an insulating film and a plurality of lines provided on the insulating film. The chip on film COF may be a general term for a form in which an insulating film formed of a thin film and lines on the insulating film are formed, and may also be referred to as a tape carrier package, a flexible printed circuit board, or the like. In the chip on film COF, a semiconductor chip connected to a portion of the lines may be further mounted on the insulating film.

The driving circuit unit DV may include a flexible circuit board. The driving circuit unit DV may include the display driver DDV. The driving circuit unit DV may be disposed on a rear surface of the first base layer BS1 of the display panel DP. One end of the driving circuit unit DV may be connected to the chip on film COF having a bent shape and may be disposed on the rear surface of the first base layer BS1, and thus the driving circuit unit DV might not be externally visible.

Referring to FIG. 3, the touch sensing unit TSP may obtain information on the touch input from the user. The information on the touch input (or a touch event) may mean information including a position or the like of a touch that the user wishes to provide. The touch sensing unit TSP may be configured to recognize the touch input.

A second base layer BS2 (or the display device DD) may include a sensing area SA capable of sensing the touch input, or the like, and a non-sensing area NSA adjacent to the sensing area SA. According to an embodiment of the present disclosure, the sensing area SA may overlap at least one area of the display area DA. For example, the sensing area SA may be set to an area corresponding to the display area DA (for example, an area overlapping the display area DA), and the non-sensing area NSA may be set to an area corresponding to the non-display area NDA (for example, an area overlapping the non-display area NDA). In this case, when the touch input or the like is provided on the display area DA, the touch input may be detected through the touch sensing unit TSP.

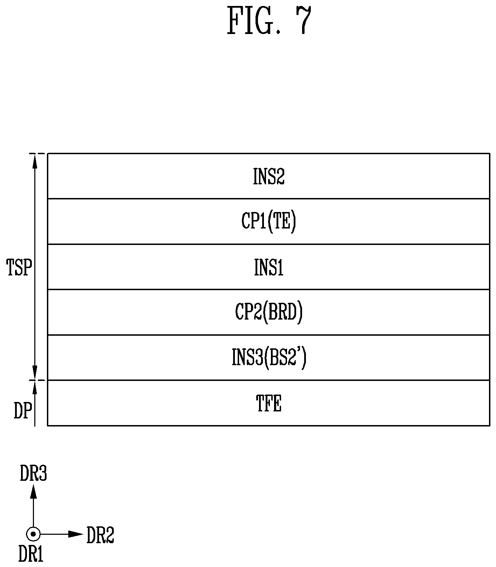

The second base layer BS2 may include one or more insulating layers (for example, a third insulating layer INS3 of FIG. 7). For example, the third insulating layer INS3 for forming the second base layer BS2 may be disposed on the display panel DP to form a base for forming the touch electrodes TE. However, an example for forming the second base layer BS2 is not necessarily particularly limited thereto.

The sensing area SA may be defined as an area that may respond to the touch input (for example, an active area of a sensor). To this end, touch electrodes TE for sensing the touch input or the like may be disposed in the sensing area SA.

According to an embodiment (for example, a mutual capacitance type), the touch electrodes TE may include a transmitter electrode TX that provides a first sensing signal (for example, a driving signal or a transmission signal) and a receiver electrode RX that provides a second sensing signal (for example, an output signal or a reception signal).

According to an embodiment of the present disclosure, the transmitter electrodes TX may extend along a first direction DR1. The transmitter electrodes TX may be arranged along a second direction DR2, and each of the transmitter electrodes TX may form a transmitter column.

Each of the transmitter electrodes TX may be provided as a group of fine lines. The fine lines of the transmitter electrodes TX may be disposed on a pixel defining layer PDL (refer to FIG. 5) of the display panel DP, and thus the fine lines might not overlap the emission areas of the sub-pixels SPX.

According to an embodiment of the present disclosure, the receiver electrodes RX may extend along the second direction DR2. The receiver electrodes RX may be disposed along the first direction DR1, and each of the receiver electrodes RX may form a receiver row.

Each of the receiver electrodes RX may be provided as a group of fine lines. The fine lines of the receiver electrodes RX may be disposed on the pixel defining layer PDL of the display panel DP, and thus the fine lines might not overlap the emission areas of the sub-pixels SPX.

The second direction DR2 may cross the first direction DR1. For example, the second direction DR2 may be a direction orthogonal to the first direction DR1.

The panel PNL may include a transmitter line TW, a receiver line RW, first touch sensing pads TPD1, and second touch sensing pads TPD2.

The transmitter line TW and the receiver line RW may be disposed in the non-sensing area NSA of the touch sensing unit TSP. The non-sensing area NSA may surround at least a portion of the sensing area SA. As used herein, the term "surround" may mean that the surrounding element is disposed on at least two opposite sides of the surrounded element. The non-sensing area NSA may include the pad area PDA. The pad area PDA may be disposed in the non-sensing area NSA. The pad area PDA may be disposed on one side of the sensing area SA.

The transmitter electrode TX may include a plurality of transmitter electrodes TX each forming a transmitter column. For example, the transmitter electrode TX may include first to n-th transmitter electrodes TX1 to TXn (wherein n is an integer of 2 or more). Each of the first to n-th transmitter electrodes TX1 to TXn may extend in the first direction DR1 and may be sequentially arranged in the second direction DR2.

One end of the transmitter line TW may be electrically connected to the transmitter electrode TX, and another end may be electrically connected to a first touch sensing pad TPD1. According to an embodiment of the present disclosure, the transmitter line TW may be a trace line for the transmitter electrode TX.

The transmitter line TW may include a plurality of transmitter lines TW respectively electrically connected to different transmitter electrodes TX. For example, the transmitter line TW may include a first transmitter line TW1 electrically connected to a first transmitter electrode TX1, a second transmitter line TW2 electrically connected to a second transmitter electrode TX2, ..., a n-1-th transmitter line TWn-1 electrically connected to a n-1-th transmitter electrode TXn-1, and a n-th transmitter line TWn electrically connected to a n-th transmitter electrode TXn.

The receiver electrode RX may include a plurality of receiver electrodes RX each forming a receiver row. For example, the receiver electrode RX may include first to m-th receiver electrodes RX1 to RXm (wherein m is defined independently from n, and is an integer of 2 or more). Each of the first to m-th receiver electrodes RX1 to RXm may extend in the second direction DR2 and may be sequentially arranged along the first direction DR1.

One end of the receiver line RW may be electrically connected to the receiver electrode RX, and another end may be electrically connected to a second touch sensing pad TPD2. According to an embodiment of the present disclosure, the receiver line RW may be a trace line for the receiver electrode RX.

The receiver line RW may include a plurality of receiver lines RW respectively electrically connected to different receiver electrodes RX. For example, the receiver line RW may include a first receiver line RW1 electrically connected to a first receiver electrode RX1 and a second receiver line RW2 electrically connected to a second receiver electrode RX2.

The first touch sensing pads TPD1 and the second touch sensing pads TPD2 may be disposed in the pad area PDA.

The first touch sensing pads TPD1 may be electrically connected to the transmitter electrode TX in the sensing area SA through the transmitter line TW. The second touch sensing pads TPD2 may be electrically connected to the receiver electrode RX in the sensing area SA through the receiver line RW.

The first touch sensing pads TPD1 and the second touch sensing pads TPD2 may be electrically connected to the sensor driver SDV formed in the driving circuit unit DV through the chip on film COF.

For example, an electrical signal provided by the sensor driver SDV may be applied to the touch electrodes TE through the first touch sensing pads TPD1 and the second touch sensing pads TPD2. According to an embodiment of the present disclosure, the first touch sensing pads TPD1 may be a Tx pad, and the second touch sensing pads TPD2 may be an Rx pad.

According to an embodiment of the present disclosure, the touch sensing unit TSP may have a predetermined electrode structure, and thus the touch sensing unit TSP with increased visibility may be provided.

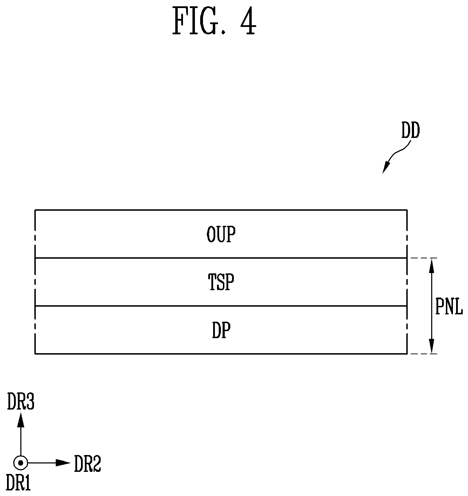

Hereinafter, with reference to FIGS. 4 to 20, a display device DD including a touch sensing unit TSP having one electrode structure is described.

First, with reference to FIG. 4, a cross-sectional structure of a display device DD according to an embodiment is described. FIG. 4 is a schematic cross-sectional view illustrating a stack structure of a display device according to an embodiment of the present disclosure.

Referring to FIG. 4, the touch sensing unit TSP may be disposed on the display panel DP. The display device DD may further include an outer unit OUP.

The outer unit OUP may be disposed in an upper portion of the display device DD based on a direction in which the display panel DP, the touch sensing unit TSP, and the outer unit OUP are sequentially stacked (for example, the third direction DR3). The outer unit OUP may be disposed on the touch sensing unit TSP. Light emitted from the display panel DP may pass through the outer unit OUP and may be externally output. According to an embodiment of the present disclosure, the outer unit OUP may include a window. According to an embodiment of the present disclosure, the outer unit OUP may include a reflection adjustment layer and a light blocking layer. According to an embodiment of the present disclosure, the outer unit OUP may further include color filters.

Next, with reference to FIG. 5, an embodiment of the display panel DP is described.

FIG. 5 is a cross-sectional view illustrating a stack structure of a display panel according to an embodiment of the present disclosure.

Referring to FIG. 5, the display panel DP may include a pixel circuit layer PCL and a light emitting element layer DEL.

According to an embodiment of the present disclosure, the display panel DP may output visual information (for example, an image). According to an embodiment of the present disclosure, a type/kind of the display panel DP is not necessarily particularly limited thereto. For example, the display panel DP may be implemented as a self-emission type of display panel such as an organic light emitting display panel (OLED). However, when the display panel DP is implemented as a self-emission type, each pixel is not necessarily limited to a case where each pixel includes only an organic light emitting element. For example, a light emitting element of each pixel may be formed of an organic light emitting diode, an inorganic light emitting diode, a quantum dot/well light emitting diode, or the like. According to an embodiment of the present disclosure, the display panel DP may be implemented as a non-emission type of display panel such as a liquid crystal display panel (LCD). When the display panel DP is implemented as a non-emission type, the display device DD may additionally include a light source such as a back-light unit.

Hereinafter, for convenience of description, the description is based on an embodiment in which the display panel DP is implemented as an organic light emitting diode (OLED) display panel.

The pixel circuit layer PCL may include a pixel circuit PXC for driving the light emitting elements LD. The pixel circuit layer PCL may include a first base layer BS1, conductive layers for forming the pixel circuits PXC, and insulating layers disposed between the conductive layers.

The pixel circuit PXC may include a driving transistor. The pixel circuit PXC may be electrically connected to the light emitting elements LD and may provide an electrical signal for the light emitting elements LD to emit light.

The light emitting element layer DEL may be disposed on the pixel circuit layer PCL. According to an embodiment of the present disclosure, the light emitting element layer DEL may include the light emitting element LD, a capping layer CPL, the pixel defining layer PDL, and a thin film encapsulation layer TFE.

The light emitting element LD may be disposed on the pixel circuit layer PCL. According to an embodiment of the present disclosure, the light emitting element LD may include a first electrode ELT1, a light emitting layer EL, and a second electrode ELT2. According to an embodiment of the present disclosure, the light emitting layer EL may be disposed in an area defined by the pixel defining layer PDL. The pixel defining layer PDL may be adjacent to a periphery of the light emitting layer EL. One surface of the light emitting layer EL may be electrically connected to the first electrode ELT1, and another surface of the light emitting layer EL may be electrically connected to the second electrode ELT2.

The first electrode ELT1 may be an anode electrode for the light emitting layer EL, and the second electrode ELT2 may be a common electrode (or a cathode electrode) for the light emitting layer EL. According to an embodiment of the present disclosure, the first electrode ELT1 and the second electrode ELT2 may include a conductive material. For example, the first electrode ELT1 may include a conductive material including a reflective property, and the second electrode ELT2 may include a transparent conductive material. However, the disclosure is not necessarily limited thereto.

The light emitting layer EL may have a multilayer thin film structure including a light generation layer. The light emitting layer EL may include a hole injection layer that injects a hole, a hole transport layer that has an excellent hole transport property and suppresses movement of an electron that failed to be combined in the light generation layer to increase a recombination chance of a hole and an electron, the light generation layer that emits light by recombination of the injected electron and hole, a hole blocking layer for suppressing movement of a hole that failed to be combined in the light generation layer, an electron transport layer for smoothly transporting an electron to the light generating layer, and an electron injection layer that inject an electron. The light emitting layer EL may emit light based on an electrical signal provided from the first electrode ELT1 and the second electrode ELT2.

The light emitting layer EL may form a sub-pixel SPX. The light emitting layer EL may form an emission area EMA through which light of one color is emitted. The display panel DP includes a plurality of sub-pixels SPX having emission areas EMA. In a plan view, an area of the light emitting layer EL and the emission area EMA may correspond to each other. For example, each light emitting layer EL may correspond to each emission area EMA. An area that is not the emission area EMA may be defined as a non-emission area NEMA in the display area DA. For example, an area overlapping the pixel defining layer PDL may be defined as the non-emission area NEMA.

The plane of the plan view defined in this specification is a plane formed by the first direction DR1 and the second direction DR2, and may be defined based on a plane on which the first base layer BS1 is disposed. According to an embodiment of the present disclosure, the third direction DR3 may be a thickness direction of the first base layer BS1 or an emission direction of the display device DD.

The capping layer CPL may be disposed on the light emitting element LD (for example, the second electrode ELT2). The capping layer CPL may cap the second electrode ELT2. The capping layer CPL may include an inorganic material. However, the disclosure is not necessarily limited thereto.

The pixel defining layer PDL may be disposed on the pixel circuit layer PCL. The pixel defining layer PDL may include an opening OP exposing a portion of the first electrode ELT1. The opening OP of the pixel defining layer PDL may be understood as the emission area EMA respectively corresponding to the light emitting layer EL. The pixel defining layer PDL may include an organic material. According to an embodiment of the present disclosure, the pixel defining layer PDL may include acrylic resin, epoxy resin, phenol resin, polyamide resin, and/or polyimide resin. However, the disclosure is not necessarily limited thereto.

The thin film encapsulation layer TFE may be disposed on the capping layer CPL. The thin film encapsulation layer TFE may offset a step generated by the light emitting element LD and the pixel defining layer PDL. The thin film encapsulation layer TFE may include an inorganic insulating layer including an inorganic material and/or an organic insulating layer including an organic material. The inorganic insulating layer may include, for example, silicon oxide (SiOx), silicon nitride (SiNx), silicon oxynitride (SiOxNy), and/or metal oxides such as aluminum oxide (AlOx). The organic insulating layer may include, for example, acrylic resin, epoxy resin, phenolic resin, polyamide resin, polyimide resin, unsaturated polyester resin, poly-phenylene ether resin, poly-phenylene sulfide resin, and/or benzocyclobutene resin. The thin film encapsulation layer TFE may be provided as a single layer including an organic or inorganic material, but may also be provided as multiple layers in which an organic material and an inorganic material are alternately stacked. The thin film encapsulation layer TFE may function as a buffer to protect lower layers thereof from external shock, or may include various materials suitable for protecting the lower layers thereof from oxygen and a foreign substance such as dust or moisture.

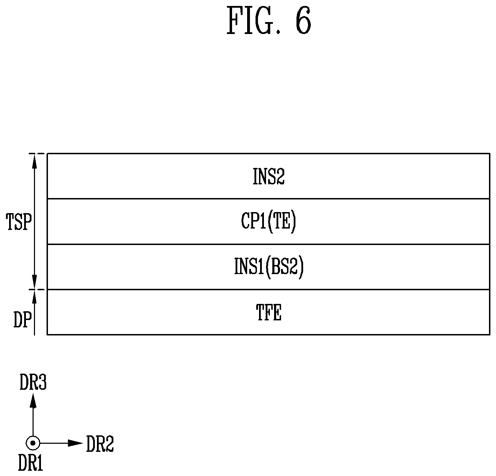

Next, with reference to FIG. 6, a cross-sectional structure of a touch sensing unit TSP according to an embodiment of the present disclosure is described.

FIG. 6 is a schematic cross-sectional view illustrating a stack structure of a touch sensing unit according to an embodiment of the present disclosure.

Referring to FIG. 6, the touch sensing unit TSP may be disposed on the display panel DP (for example, the thin film encapsulation layer TFE). The touch sensing unit TSP may include a first insulating layer INS1, a first conductive pattern layer CP1, and a second insulating layer INS2.

According to an embodiment of the present disclosure, the first conductive pattern layer CP1 may be patterned in one area to form the touch electrodes TE. For example, a portion of the first conductive pattern layer CP1 may form the transmitter electrode TX, and another portion may configure the receiver electrode RX. However, the disclosure is not necessarily limited thereto.

The first insulating layer INS1 may be disposed on the thin film encapsulation layer TFE. The first insulating layer INS1 may form a second base layer BS2 and provide an area where the first conductive pattern layer CP1 and the second insulating layer INS2 are disposed on the thin film encapsulation layer TFE. The first insulating layer INS1 may be an organic insulating layer including an organic material. The organic insulating layer may include, for example, acrylic resin, epoxy resin, phenolic resin, polyamide resin, polyimide resin, unsaturated polyester resin, poly-phenylene ether resin, poly-phenylene sulfide resin, and/or benzocyclobutene resin. However, a material of the first insulating layer INS1 is not necessarily limited thereto. For example, the first insulating layer INS1 may include an inorganic insulating layer including an inorganic material.

The first conductive pattern layer CP1 may include a single layer or multiple metal layers. The first conductive pattern layer CP1 may include metal materials such as gold (Au), silver (Ag), aluminum (Al), molybdenum (Mo), chromium (Cr), titanium (Ti), nickel (Ni), neodymium (Nd), copper (Cu), platinum (Pt), and/or an alloy thereof. According to an embodiment of the present disclosure, the first conductive pattern layer CP1 may include various transparent conductive materials including silver nanowire (AgNW), indium tin oxide (ITO), indium zinc oxide (IZO), indium gallium zinc oxide (IGZO), antimony zinc oxide (AZO), indium tin zinc oxide (ITZO), zinc oxide (ZnO), tin oxide (SnO2), carbon nano tube, and/or graphene, but is not necessarily limited thereto. For example, the first conductive pattern layer CP1 may have a multilayer structure of Ti/Al/Ti.

The second insulating layer INS2 may be disposed on the first conductive pattern layer CP1. As will be described later, the second insulating layer INS2 may cover the first conductive pattern layer CP1 and the first insulating layer INS1, and may offset a step generated by the first conductive pattern layer CP1 and the first insulating layer INS1. In addition, the second insulating layer INS2 may provide an area where the reflection adjustment layer, the light blocking layer, and/or the color filters of the outer unit OUP are disposed. The second insulating layer INS2 may include an inorganic insulating layer including an inorganic material and/or an organic insulating layer including an organic material, similarly to the thin film encapsulation layer TFE.

Next, with reference to FIG. 7, a modified example of the stack structure of the touch sensing unit TSP is described. FIG. 7 is a schematic cross-sectional view illustrating a stack structure of a touch sensing unit according to another embodiment of the present disclosure.

Referring to FIG. 7, the touch sensing unit TSP may include a third insulating layer INS3, a second conductive pattern layer CP2, a first insulating layer INS1, a first conductive pattern layer CP1, and a second insulating layer INS2. The first insulating layer INS1, the first conductive pattern layer CP1, and the second insulating layer INS2 may be configured similarly to the first insulating layer INS1, the first conductive pattern layer CP1, and the second insulating layer INS2 described with reference to FIG. 6. To the extent that an element is not described in detail with respect to this figure, it may be understood that the element is at least similar to a corresponding element that has been described elsewhere within the present disclosure.

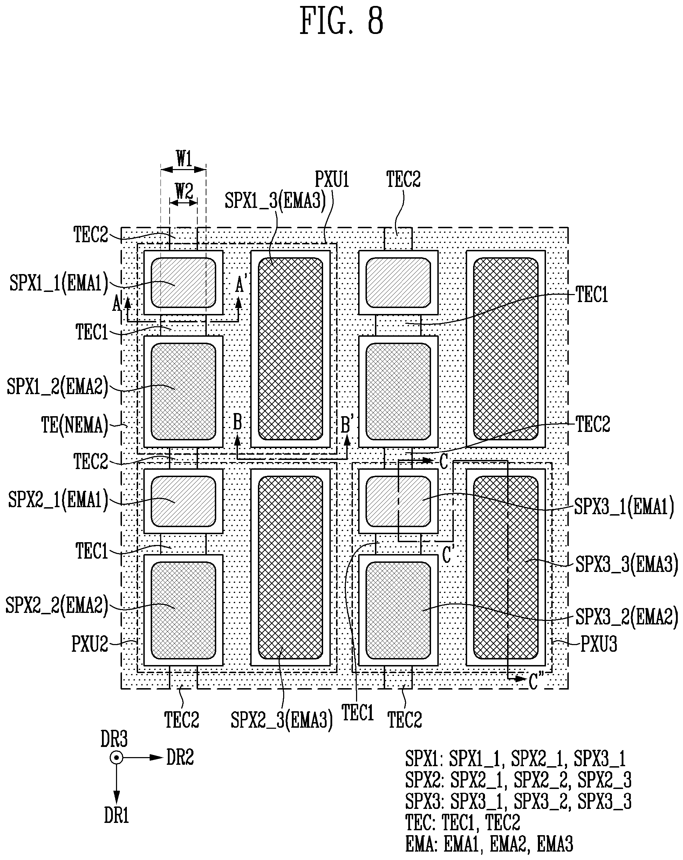

According to an embodiment of the present disclosure, the second conductive pattern layer CP2 may be patterned in one area to form a plurality of bridges BRD that electrically connect touch electrodes TE adjacent to each other. The bridge BRD may be electrically connected to the first conductive pattern layer CP1 by a conductive material filled in a contact hole formed in the first insulating layer INS1. For example, the transmitter electrodes TX adjacent to each other may be electrically separated from each other on the first conductive pattern layer CP1, but may be electrically connected to each other through one bridge BRD formed in the second conductive pattern layer CP2. In addition, the receiver electrodes RX adjacent to each other may be electrically separated from each other on the first conductive pattern layer CP1, but may be electrically connected to each other through one bridge BRD formed in the second conductive pattern layer CP2. At this time, a portion of the touch electrode TE connected to the bridge BRD may be a remaining portion except for a recess (refer to TEC of FIG. 8) of the touch electrode TE to be described in detail with reference to FIG. 8 below.

The third insulating layer INS3 may be disposed between the thin film encapsulation layer TFE and the second conductive pattern layer CP2. The third insulating layer INS3 may form a second base layer BS2' to provide an area where the second conductive pattern layer CP2, the first insulating layer INS1, the first conductive pattern layer CP1, and the second insulating layer INS2 are disposed.

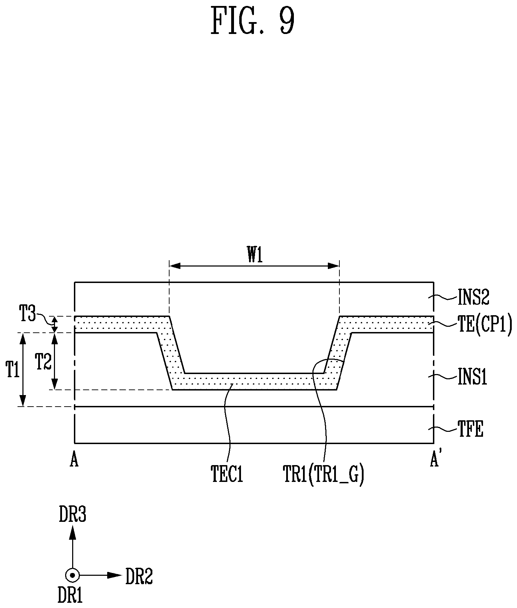

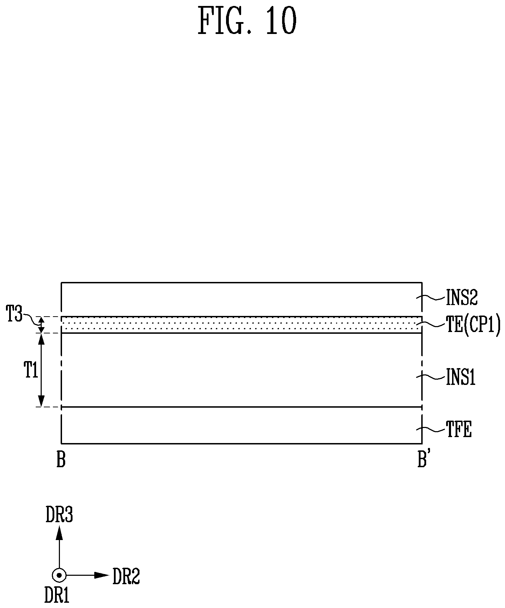

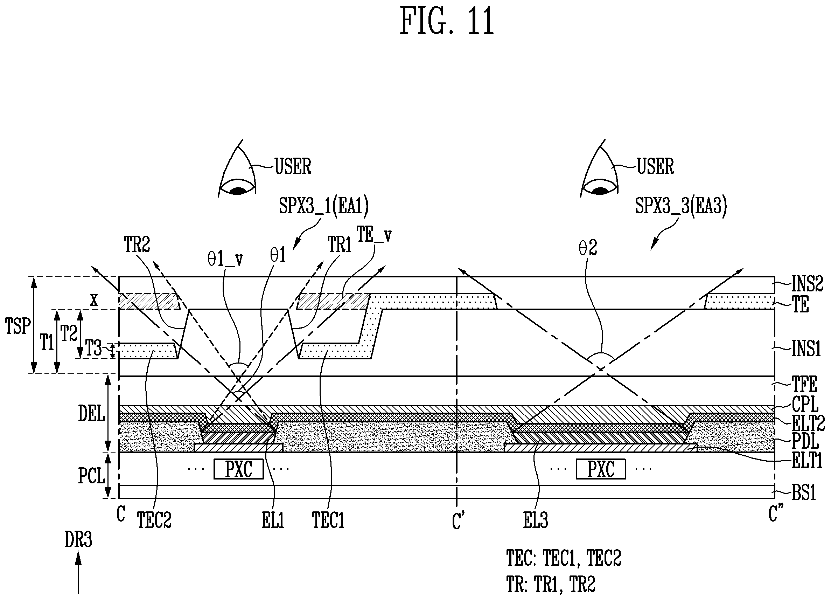

Next, a structure of the touch electrode is described in more detail with reference to FIGS. 8 to 11. FIG. 8 illustrates a structure of touch electrodes according to an embodiment together with emission areas, and is an enlarged plan view of an area AA of FIG. 2. FIG. 9 is a cross-sectional view taken along portion A-A' of FIG. 8. FIG. 10 is a cross-sectional view taken along portion B-B' of FIG. 8. FIG. 11 is a cross-sectional view taken along portion C-C'-C" of FIG. 8.

Referring to FIG. 8, a plurality of pixel units are provided. In FIG. 8, for convenience of description, first to third pixel units PXU1, PXU2, and PXU3 are indicated by dotted boxes. The first pixel unit PXU1 may include a (1_1)-th sub-pixel SPX1_1, a (1_2)-th sub-pixel SPX1_2, and a (1_3)-th sub-pixel SPX1_3. The second pixel unit PXU2 may include a (2_1)-th sub-pixel SPX2_1, a (2_2)-th sub-pixel SPX2_2, and a (2_3)-th sub-pixel SPX2_3. The third pixel unit PXU3 may include a (3_1)-th sub-pixel SPX3_1, a (3_2)-th sub-pixel SPX3_2, and a (3_3)-th sub-pixel SPX3_3. The first pixel unit PXU1 and the second pixel unit PXU2 may be disposed adjacent to each other along the first direction DR1. The second pixel unit PXU2 and the third pixel unit PXU3 may be disposed adjacent to each other along the second direction DR2.

Each of the (1_1)-th sub-pixel SPX1_1, the (2_1)-th sub-pixel SPX2_1, and the (3_1)-th sub-pixel SPX3_1 may emit light of the same color (for example, red) and may have an emission area of substantially the same area. For convenience of description below, the (1_1)-th sub-pixel SPX1_1, the (2_1)-th sub-pixel SPX2_1, and the (3_1)-th sub-pixel SPX3_1 are referred to as a first sub-pixel SPX1. Each of the (1_2)-th sub-pixel SPX1_2, the (2_2)-th sub-pixel SPX2_2, and the (3_2)-th sub-pixel SPX3_2 may emit light of the same color (for example, green) and may have an emission area of substantially the same area. For convenience of description below, the (1_2)-th sub-pixel SPX1_2, the (2_2)-th sub-pixel SPX2_2, and the (3_2)-th sub-pixel SPX3_2 are referred to as a second sub-pixel SPX2. Each of the (1_3)-th sub-pixel SPX1_3, the (2_3)-th sub-pixel SPX2_3, and the (3_3)-th sub-pixel SPX3_3 emit light of the same color (for example, blue) and may have an emission area of substantially the same area. For convenience of description below, the (1_3)-th sub-pixel SPX1_3, the (2_3)-th sub-pixel SPX2_3, and the (3_3)-th sub-pixel SPX3_3 are referred to as a third sub-pixel SPX3. This is because the respective first sub-pixel SPX1, second sub-pixel SPX2, and third sub-pixel SPX3 have in common that the respective first sub-pixel SPX1, second sub-pixel SPX2, and third sub-pixel SPX3 are positioned in the same place in the first pixel unit PXU1, the second pixel unit PXU2, and the third pixel unit PXU3 in a plan view. In addition, hereinafter, when at least one pixel is arbitrarily referred to or when two or more types of pixels are comprehensively referred to among the first to third sub-pixels SPX1, SPX2, and SPX3, at least one pixel or two or more types of pixels are referred to as "sub-pixel SPX" or "sub-pixels SPX". In addition, for convenience of description, the light emitting layer EL positioned in the first sub-pixel SPX1 is referred to as a first light emitting layer EL1, the light emitting layer EL positioned in the second sub-pixel SPX2 is referred to as a second light emitting layer, and the light emitting layer EL positioned in the third sub-pixel SPX3 is referred to as a third light emitting layer EL3.

For example, the first sub-pixel SPX1 may be positioned in an upper left end of each of the first to third pixel units PXU1, PXU2, and PXU3, the second sub-pixel SPX2 may be positioned in a lower left end of each of the first to third pixel units PXU1, PXU2, and PXU3, and the third sub-pixel SPX3 may be positioned in a right side of each of the first to third pixel units PXU1, PXU2, and PXU3. However, the number, a shape, or a position of the first to third sub-pixels SPX1, SPX2, and SPX3 is not necessarily limited thereto and various modifications are possible. For example, two third sub-pixel SPX3 may be provided rather than one third sub-pixel SPX3, a shape of the first to third sub-pixels SPX1, SPX2, and SPX3 may also be changed to a diamond shape or the like, and a disposition thereof may also be arranged side by side along a direction crossing both of the first direction DR1 and the second direction DR2 or may be arranged in a zigzag manner.

The touch electrode TE may be disposed on the display panel DP and may overlap the non-emission area NEMA adjacent to the emission areas EMA. When expressing this differently, the touch electrode TE may surround at least a portion of each of the plurality of sub-pixels SPX in a plan view. For example, the touch electrode TE may be disposed on a front surface of the thin film encapsulation layer TFE, and a partial area overlapping the emission area EMA of FIG. 5 defined by the plurality of sub-pixels SPX may be opened to have a mesh structure surrounding each of the sub-pixels SPX. For example, the touch electrode TE may be disposed on the non-emission area NEMA overlapping the pixel defining layer PDL shown in FIG. 5.

According to this structure, the touch electrode TE may surround peripheries of each of the (1_1)-th to (1_3)-th sub-pixels SPX1_1, SPX1_2, and SPX1_3 configuring the first pixel unit PXU1, the (2_1)-th to (2_3)-th sub-pixels SPX2_1, SPX2_2, and SPX2_3 configuring the second pixel unit PXU2, and the (3_1)-th to (3_3)-th sub-pixels SPX3_1, SPX3_2, and SPX3_3 configuring the third pixel unit PXU3.

The touch electrode TE may include a first recess TEC1 recessed in a direction facing the display panel DP (a direction opposite to the third direction DR3 in the drawing) and overlapping a portion of the non-emission area NEMA positioned between the first emission area EMA1 and the second emission area EMA2. The recess may, in other words, be referred to as recessed portion of the touch electrode TE. Since the touch electrode TE includes the first recess TEC1 recessed in the direction facing the display panel DP thereby having reduced height with respect to the display panel DP, a viewing angle of the display device DD may be widened and a color shift phenomenon may be reduced.

Each of the pixel units PXU1, PXU2, and PXU3 may include the first sub-pixel SPX1 having the first emission area EMA1, the second sub-pixel SPX2 having the second emission area EMA2, and the third sub-pixel SPX3 having the third emission area EMA3 adjacent to at least one of the first and second emission areas EMA1 and EMA2. For example, the first and second emission areas EMA1 and EMA2 of each pixel unit may be arranged along the first direction DR1 to form first columns. The third emission area EMA3 of each pixel unit may be arranged along the first direction DR1 to form second columns. The first columns and the second columns may be alternately arranged along the second direction DR2. As shown in the drawing, the second emission area EMA2 may be greater than the first emission area EMA1, and the third emission area EMA3 may be greater than the second emission area EMA2.

As shown in FIG. 8, the second emission area EMA2 of any pixel unit (for example, PXU1) may be adjacent to the first emission area EMA1 of a neighboring pixel unit (for example, PXU2) in a direction opposite to the first direction DR1. For example, the second emission area EMA2 of any pixel unit (for example, PXU1) may be disposed between the first emission area EMA1 included in the same pixel unit (for example, PXU1) and the first emission area EMA1 included in the neighboring pixel unit (for example, PXU2).

The touch electrode TE may further include a second recess TEC2. The second recess TEC2 may overlap a portion of the non-emission area NEMA positioned between the second emission area EMA2 of any pixel unit and the first emission area EMA1 of a neighboring pixel unit. Since the touch electrode TE may include a second recess TEC2 recessed in the direction facing the display panel DP on a boundary line, a viewing angle of the first emission area EMA1 having the smaller area may be further widened and a color shift phenomenon may be reduced. At this time, a width W1 of the first recess TEC1 in the second direction DR2 may be different from a width W2 of the second recess TEC2 of the second direction DR2. For example, the width W1 of the first recess TEC1 of the second direction DR2 may be greater than the width W2 of the second recess TEC2 of the second direction DR2. Hereinafter, for convenience of description, in a case where there is no need to distinguish between the first recess TEC1 and the second recess TEC2, the first recess TEC1 and the second recess TEC2 is unified and expressed as "recess TEC."

The first insulating layer INS1 may be disposed between the display panel DP, for example the thin film encapsulation layer TFE, and the touch electrode TE, and may include a trench TR recessed in the direction facing the display panel DP (the direction opposite to the third direction DR3). In embodiments, the touch electrode TE may be formed in chemical vapor deposition (CVD) on the first insulating layer INS1. In addition, the trench TR may be formed by removing a portion of the first insulating layer INS1 using a photolithography method.

The recess TEC may be disposed on the trench TR. At this time, the trench TR may include various shapes so that a portion of the touch electrode TE overlapping the trench TR is provided as the recess TEC. For example, the trench TR may be understood as a groove, a recess, and/or a through hole.

The first insulating layer INS1 may be an organic insulating layer including an organic material. Since the first insulating layer INS1 shown in FIGS. 8 to 11 may be configured similarly to the first insulating layer INS1 described with reference to FIG. 6, it may be understood that the element is at least similar to a corresponding element that has been described elsewhere within the present disclosure.

Referring to FIGS. 9 and 11, the trench TR may include an inclined surface based on a thickness direction (for example, the third direction DR3) of the first insulating layer INS1, and may include a first trench TR1 receiving the first recess TEC1 and a second trench TR2 receiving the second recess TEC2. At this time, the first recess TEC1 and the second recess TEC2 might not be electrically connected to the bridge BRD as described with reference to FIG. 7. The touch sensing unit TSP might not include a conductor in a lower portion of the first recess TEC1 and the second recess TEC2.

Referring to FIGS. 9 and 11, a depth T2 of the first trench TR1 may be less than a thickness T1 of the first insulating layer INS1. Thus, a lower portion of the first insulating layer INS1 may function as a base substrate or base member on which the touch electrode TE is formed. When the depth T2 of the first trench TR1 is less than the thickness T1 of the first insulating layer INS1, the first trench TR1 may be referred to as a first trench groove TR1_G. In addition, a thickness T3 of the touch electrode TE may be less than the depth T2 of the first trench TR1. The first recess TEC1 may be disposed in the first trench groove TR_G.

According to this structure, a viewing angle of the display device DD may be widened and a color shift phenomenon may be reduced.

For example, referring to FIG. 11, by a structure in which the recess TEC is received in the trench TR, a viewing angle formed by the first light emitting layer EL1 and the touch electrode TE may be defined as θ1. Assuming that the trench TR is not formed in the first insulating layer INS1, the recess TEC may be disposed on the uppermost surface x of the first insulating layer INS1 (for example, a position of the touch electrode TE_v), and in this case, the viewing angle formed by the first light emitting layer EL1 and the touch electrode TE_v may be θ1_v, which is less than θ1. Accordingly, as the recess TEC is received in the trench TR adjacent to the sub-pixel SPX, the viewing angle of the display device DD may be widened. When the viewing angle is expanded as described above, the user may sufficiently recognize all light of various colors.

For example, when all uppermost surfaces of the touch electrode TE are positioned at the same height, the viewing angle formed by the light emitting layer EL and the touch electrode TE may be different according to a size of the light emitting layer EL. For example, as shown in FIG. 11, in a case of the (3_3)-th sub-pixel SPX3_3 having the relatively large area EA3, a viewing angle formed by the third light emitting layer EL3 and the touch electrode TE may be θ2, which may be greater than the viewing angle θ1_v formed by the first light emitting layer EL1 and the touch electrode TE_v when the trench TR is not formed in the first insulating layer INS1. For example, in a case of a sub-pixel having the relatively large area, a light amount recognized by the user may be sufficiently secured even from a side surface by securing a sufficient viewing angle even though the trench TR is not formed. On the other hand, in a case of the (1_1)-th sub-pixel SPX1_1 having the relatively small area EA1, as the viewing angle θ1 is less than the θ1_v and θ2 as described above, a light amount recognized by the user from the side surface may rapidly decrease. This may cause a color shift phenomenon in which light of a specific color is recognized excessively. According to an embodiment of the present disclosure, a height of the first insulating layer INS1 where the touch electrode TE is disposed may be lowered using a structure such as the trench TR. Therefore, a viewing angle formed by the light emitting layer EL, which is a light source, and the touch electrode TE may be widened, and thus a light amount recognized by the user may increase. Accordingly, the color shift phenomenon may be reduced.

According to an embodiment of the present disclosure, as shown in FIG. 11, the depth of the first trench TR1 and the second trench TR2 may be substantially the same as T2, but is not necessarily limited thereto. For example, the depths of the first trench TR1 and the second trench TR2 may be different from each other. However, even in this case, the depth of the first trench TR1 may correspond to or may be greater than the thickness of the first recess TEC1, and the depth of the second trench TR2 may correspond to or may be greater than the thickness of the second recess TEC2. This is for implementing a structure in which an angle formed by the first light emitting layer EL1 and the touch electrode TE is greater than the angle θ1_v formed by the first light emitting layer EL1 and the touch electrode TE when the first recess TEC1 and the second recess TEC2 are positioned at the uppermost surface x of the first insulating layer INS1 by disposing both of the first recess TEC1 and the second recess TEC2 at a position lower than the uppermost surface x of the first insulating layer INS1 based on a thickness direction (for example, the third direction DR3) of each of components.

In addition, referring to FIG. 8, the width W1 of the first recess TEC1 of the second direction DR2 may be different from the width W2 of the second recess TEC2 of the second direction DR2. Since the first recess TEC1 is disposed between the first sub-pixel SPX1 having the smallest area in one pixel unit (for example, the first pixel unit PXU1) and the second sub-pixel SPX2 having the middle area, an effect of improving the color shift phenomenon as described above may be strengthened in one pixel unit PXU. In addition, since the second recess TEC2 is disposed between the first sub-pixel SPX1 and the second sub-pixel SPX2 adjacent to each other based on a boundary line of the first pixel unit PXU1 and the second pixel unit PXU2, the color shift phenomenon may be reduced by further expanding a viewing angle of the first sub-pixel SPX1 having the smallest area. However, embodiments are not necessarily limited thereto, and for example, the widths of the first recess TEC1 and the second recess TEC2 may be substantially the same. In this case, the color shift phenomenon may be reduced by expanding the viewing angle of the first sub-pixel SPX1 having the smallest area.

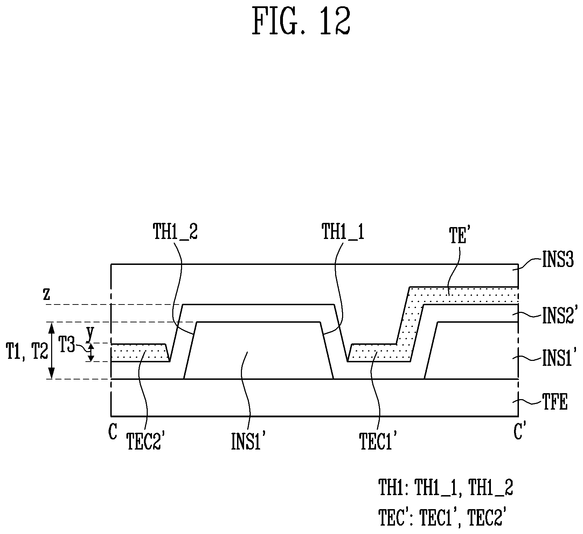

FIG. 12 illustrates a touch sensing unit according to an embodiment of the present disclosure, and is a modified example illustrated by taken portion C-C' of FIG. 8. Configurations of the pixel circuit layer PCL and the light emitting element layer DEL shown in FIG. 11 may be disposed identically under the thin film encapsulation layer TFE shown in FIG. 12.

Referring to FIG. 12, a first insulating layer INS1' may be partially removed to include a first through hole TH1 exposing a portion of an upper surface of the thin film encapsulation layer TFE. For example, in a state in which the first insulating layer INS1' is disposed on the display panel DP, for example on the thin film encapsulation layer TFE, the first through hole TH1 may be a component formed in the first insulating layer INS1' when the depth T2 of the trench TR described with reference to FIGS. 8 to 11 is the same as a thickness T1 of the first insulating layer INS1'. For example, the first through hole TH1 shown in FIG. 12 may be a component in which the first insulating layer INS1' as much as the thickness T1 is removed so that the first through hole TH1 passes through a partial area of the first insulating layer INS1'. The first through hole TH1 may include a (1_1)-th through hole TH1_1 overlapping a first recess TEC1' and a (1_2)-th through hole TH1_2 overlapping a second recess TEC2'.

A second insulating layer INS2' may be disposed on the first insulating layer INS1' and a portion of the upper surface of the thin film encapsulation layer TFE exposed by the (1_1)-th through hole TH1_1 and the (1_2)-th through hole TH1_2. The second insulating layer INS2' may function as a base substrate or base member on which a touch electrode TE' is formed. The second insulating layer INS2' may be an inorganic insulating layer including an inorganic material. For example, the second insulating layer INS2' may include silicon nitride (SiNx), silicon oxide (SiOx), silicon oxynitride (SiOxNy), and/or metal oxides such as aluminum oxide (AlOx). However, a material of the second insulating layer INS2' is not necessarily limited thereto. For example, the second insulating layer INS2' may include an organic insulating layer including an organic material.

According to an embodiment of the present disclosure, a recess TEC' may be disposed on a portion of the second insulating layer INS2' overlapping the first through hole TH1. The uppermost surface y of the recess TEC' positioned at the lowest position may be positioned lower than the uppermost surface z of the second insulating layer INS2 disposed on the first insulating layer INS1'. For example, at least a portion of the recess TEC' may be positioned at a position lower than the uppermost surface z of the second insulating layer INS2 disposed on the first insulating layer INS1'. According to this structure, since the recess TEC' is disposed at a position (for example, y) lower than the uppermost surface z of the second insulating layer INS2' on the first insulating layer INS1' where the touch electrode TE' is to be positioned when the first through hole TH1 does not exist, the effect of expanding the viewing angle and improving the color shift as described with reference to FIG. 11 may be identically expected.

In addition, the third insulating layer INS3 may be disposed on the second insulating layer INS2' and the touch electrode TE'. The third insulating layer INS3 may be configured similarly to the thin film encapsulation layer TFE, and may function as a buffer to protect lower layers thereof by covering lower components such as the touch electrode TE', the first insulating layer INS1', and the second insulating layer INS2' from external shock, or may include various materials suitable for protecting the lower layers thereof from oxygen and a foreign substance such as dust or moisture. In addition, the third insulating layer INS3 may offset a step generated by the touch electrode TE', and the first insulating layer INS1' and the second insulating layer INS2'. In addition, the third insulating layer INS3 shown in FIG. 12 may provide an area where the reflection adjustment layer, the light blocking layer, and/or the color filters of the outer unit OUP are disposed, similarly to the second insulating layer INS2 of FIG. 6.

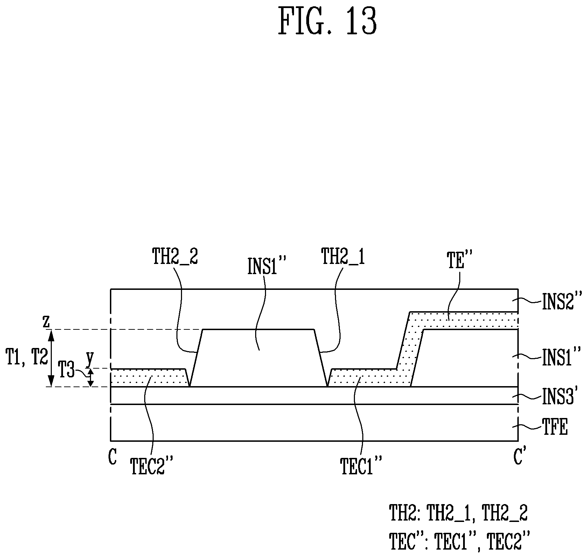

FIG. 13 illustrates a touch sensing unit according to an embodiment of the present disclosure, and is a modified example of a cross-sectional view illustrated by taken portion C-C' of FIG. 8. Configurations of the pixel circuit layer PCL and the light emitting element layer DEL shown in FIG. 11 may be disposed identically under the thin film encapsulation layer TFE shown in FIG. 13.

Referring to FIG. 13, a third insulating layer INS3' may be disposed between the display panel DP, for example on the thin film encapsulation layer TFE, and a first insulating layer INS1". The third insulating layer INS3' may function as a base substrate or a base member on which a touch electrode TE" is formed. The third insulating layer INS3' may be an inorganic insulating layer including an inorganic material. For example, the third insulating layer INS3' may include silicon nitride (SiNx), silicon oxide (SiOx), silicon oxynitride (SiOxNy), and/or metal oxides such as aluminum oxide (AlOx). However, a material of the third insulating layer INS3' is not necessarily limited thereto. For example, the third insulating layer INS3' may include an organic insulating layer including an organic material.

The first insulating layer INS1" may be partially removed to include a second through hole TH2 exposing a portion of the third insulating layer INS3'. For example, in a state in which the third insulating layer INS3' is disposed on the thin film encapsulation layer TFE, the second through hole TH2 may be a component formed in the first insulating layer INS1 when the depth T2 of the trench TR described with reference to FIGS. 8 to 11 is the same as the thickness T1 of the first insulating layer INS1. For example, the second through hole TH2 shown in FIG. 13 may be a component in which the first insulating layer INS1" as much as the thickness T1 is removed so that the second through hole TH2 passes through a partial area of the first insulating layer INS1". The second through hole TH2 may include a (2_1)-th through hole TH2_1 overlapping a first recess TEC1" and a (2_2)-th through hole TH2_2 overlapping a second recess TEC2".

A second insulating layer INS2" may be disposed on the first insulating layer INS1" and the touch electrode TE". The second insulating layer INS2" may be configured similarly to the thin film encapsulation layer TFE, and may function as a buffer to protect lower layers thereof by covering lower components such as the touch electrode TE", the first insulating layer INS1", and the third insulating layer INS3' from external shock, or may include various materials suitable for protecting the lower layers thereof from oxygen and a foreign substance such as dust or moisture. In addition, the second insulating layer INS2" may offset a step generated by the touch electrode TE", and the first insulating layer INS1" and the third insulating layer INS3'. In addition, the second insulating layer INS2" shown in FIG. 13 may provide an area where the reflection adjustment layer, the light blocking layer, and/or the color filters of the outer unit OUP are disposed, similarly to the second insulating layer INS2 of FIG. 6.

According to an embodiment of the present disclosure, a recess TEC" may be disposed on an upper surface of the third insulating layer INS3' exposed by the second through hole TH2. For example, a portion of the first recess TEC1" may be disposed on a portion of the third insulating layer INS3' exposed by the (2_1)-th through hole TH2_1, and a portion of the second recess TEC2" may be disposed on a portion of the third insulating layer INS3' exposed by the (2_2)-th through hole TH2_2.

The uppermost surface y of the recess TEC" positioned at the lowermost position may be positioned lower than the uppermost surface z of the first insulating layer INS1" disposed on the third insulating layer INS3'. For example, at least a portion of the recess TEC" may be positioned at a position lower than the uppermost surface z of the first insulating layer INS1" disposed on the third insulating layer INS3'. According to this structure, since the recess TEC" is disposed at a position (for example, y) lower than the uppermost surface z of the first insulating layer INS1" on the third insulating layer INS3" where the touch electrode TE" is to be positioned when the second through hole TH2 does not exist, the effect of expanding the viewing angle and improving the color shift as described with reference to FIG. 11 may be identically expected.

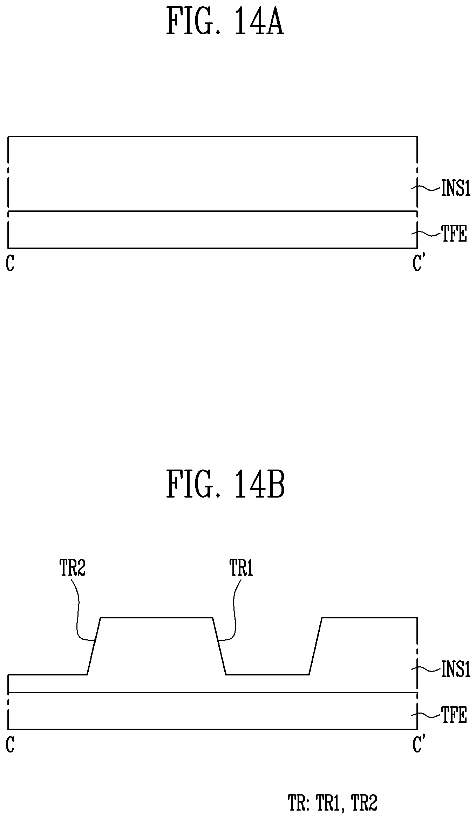

Hereinafter, a method of manufacturing the display device DD is described in detail with reference to FIGS. 14A to 16E. FIGS. 14A to 16E are cross-sectional views illustrating methods of manufacturing a display device according to embodiments for each process step. For convenience of description, the pixel circuit layer PCL and components of the remaining light emitting element layer DEL except for the thin film encapsulation layer TFE are omitted in FIGS. 14A to 16E. Since the omitted components, for example, the first base layer BS, the pixel circuit PXC, the pixel defining layer PDL, the light emitting element LD, and the capping layer CPL, may be provided by referring to a method of manufacturing a typical display device DD, to the extent that an element is not described in detail with respect to this figure, it may be understood that the element is at least similar to a corresponding element that has been described elsewhere within the present disclosure.

FIGS. 14A to 14D are cross-sectional views illustrating a method of manufacturing the touch sensing unit shown in FIG. 11.

Referring to FIG. 14A, the first insulating layer INS1 may be formed on the thin film encapsulation layer TFE. The first insulating layer INS1 may be an organic insulating layer including an organic material. The organic insulating layer may include, for example, acrylic resin, epoxy resin, phenolic resin, polyamide resin, polyimide resin, unsaturated polyester resin, poly-phenylene ether resin, poly-phenylene sulfide resin, and/or benzocyclobutene resin. However, a material of the first insulating layer INS1 is not necessarily limited thereto. For example, the first insulating layer INS1 may include an inorganic insulating layer including an inorganic material.

The first insulating layer INS1 may be formed through a thermal deposition process. The thermal deposition process for forming the first insulating layer INS1 may be performed in a temperature range that does not damage the light emitting element LD described with reference to FIG. 5. However, embodiments are not necessarily limited thereto. For example, the first insulating layer INS1 may be formed through various methods known to those skilled in the art.

Referring to FIG. 14B, the trench TR may be formed by removing a portion of the first insulating layer INS1. The trench TR may be formed through a photolithography process such as exposure and development. As described with reference to FIG. 8, the trench TR may include the first trench TR1 and the second trench TR2 having different widths in a plan view. For example, the first trench TR1 and the second trench TR2 shown in FIG. 14B may be configured similarly to the first trench TR1 and the second trench TR2 shown in FIGS. 8 and 11.

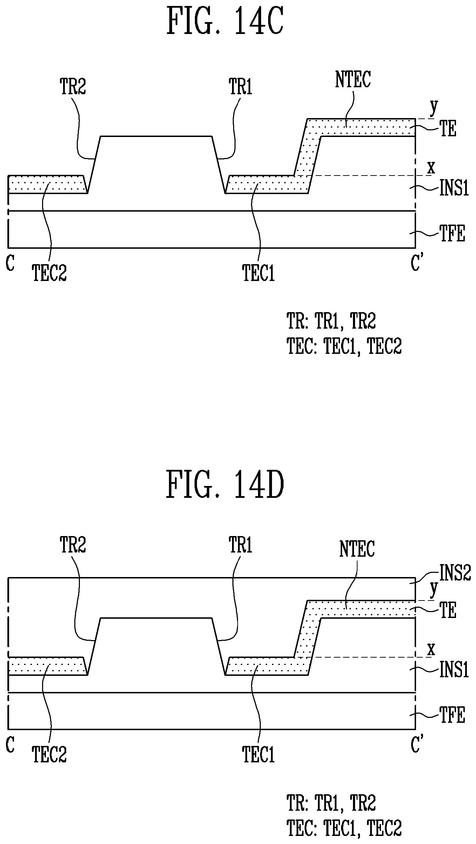

Referring to FIG. 14C, the touch electrode TE may be formed on the first insulating layer INS1. The touch electrode TE may be formed through a physical vapor deposition (PVD) method such as sputtering, a chemical vapor deposition (CVD) method, or the like, but is not necessarily limited thereto. For example, the touch electrode TE may also be formed through various methods known to those skilled in the art.

A portion of the touch electrode TE may be formed as the recess TEC received in the trench TR. Another portion of the touch electrode TE may be formed as a non-recess NTEC that is not received in the trench TR. The uppermost surface x of the recess TEC positioned at the lowest position may be positioned lower than the uppermost surface y of the non-recess NTEC. For example, at least a portion of the recess TEC may be positioned at a position lower than the uppermost surface y of the non-recess NTEC. As described with reference to FIG. 8, the recess TEC may include the first recess TEC1 and the second recess TEC2 having different widths in a plan view. For example, the first recess TEC1 and the second recess TEC2 shown in FIG. 14C may be configured similarly to the first recess TEC1 and the second recess TEC2 shown in FIGS. 8 and 11.

Referring to FIG. 14D, the second insulating layer INS2 may be formed on the first insulating layer INS1 and the touch electrode TE. The second insulating layer INS2 may be formed through substantially the same process as the first insulating layer INS1.

As described above, according to the method of manufacturing the display device shown in FIGS. 14A to 14D, at least a portion of the recess TEC may be positioned lower than the uppermost surface y of the non-recess NTEC. As a result, as described with reference to FIG. 11, the viewing angle of the display device DD may be widened, and the color shift phenomenon may be reduced as the light amount recognized by the user increases.

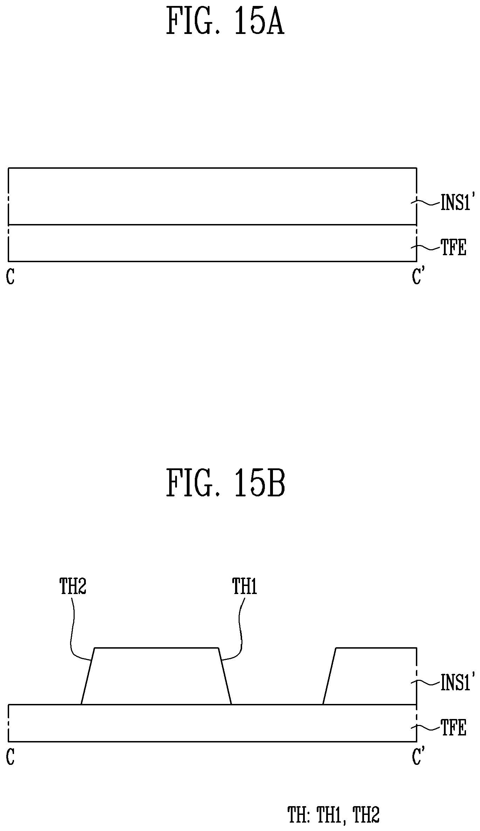

FIGS. 15A to 15E are cross-sectional views illustrating a method of manufacturing the touch sensing unit shown in FIG. 12.

Referring to FIG. 15A, the first insulating layer INS1' may be formed on the thin film encapsulation layer TFE. The first insulating layer INS1' may be an organic insulating layer including an organic material. The organic insulating layer may include, for example, acrylic resin, epoxy resin, phenolic resin, polyamide resin, polyimide resin, unsaturated polyester resin, poly-phenylene ether resin, poly-phenylene sulfide resin, and/or benzocyclobutene resin. However, a material of the first insulating layer INS1' is not necessarily limited thereto. For example, the first insulating layer INS1' may include an inorganic insulating layer including an inorganic material.

The first insulating layer INS1' may be formed through a thermal deposition process. The thermal deposition process for forming the first insulating layer INS1' may be performed in a temperature range that does not damage the light emitting element LD described with reference to FIG. 5. However, embodiments are not necessarily limited thereto. For example, the first insulating layer INS1' may be formed through various methods known to those skilled in the art.

Referring to FIG. 15B, a portion of the first insulating layer INS1' may be removed to form the through hole TH exposing a portion of the upper surface of the thin film encapsulation layer TFE. The through hole TH may be formed through a photolithography process such as exposure and development. The through hole TH may include the first through hole TH1 and the second through hole TH2 having different widths, as described with reference to FIGS. 8 and 12. For example, the first through hole TH1 and the second through hole TH2 shown in FIG. 15B may be configured similarly to the (1_1)-th through hole TH1_1 and the (1_2)-th through hole TH1_2 shown in FIG. 12.

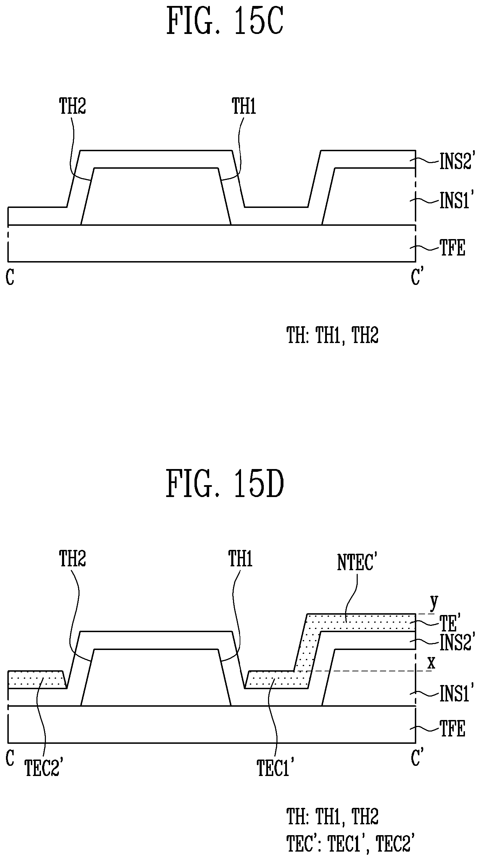

Referring to FIG. 15C, the second insulating layer INS2' may be formed on the first insulating layer INS1' and a portion of the upper surface of the thin film encapsulation layer TFE exposed by the through hole TH. The second insulating layer INS2' may be an inorganic insulating layer including an inorganic material. For example, the second insulating layer INS2' may include silicon nitride (SiNx), silicon oxide (SiOx), silicon oxynitride (SiOxNy), and/or metal oxides such as aluminum oxide (AlOx). However, a material of the second insulating layer INS2' is not necessarily limited thereto. For example, the second insulating layer INS2' may include an organic insulating layer including an organic material.

According to an embodiment of the present disclosure, the second insulating layer INS2' may be formed using an atomic layer deposition (ALD) method, a sol-gel process, a chemical deposition method (for example, plasma enhanced chemical vapor deposition (PECVD)), or the like, but this is merely an example, and is not necessarily limited thereto. For example, the second insulating layer INS2' may be formed through various methods known to those skilled in the art.

Referring to FIG. 15D, the touch electrode TE' may be formed on the second insulating layer INS2'. The touch electrode TE' may be formed through a physical vapor deposition (PVD) method such as sputtering, a chemical vapor deposition (CVD) method, or the like, but is not necessarily limited thereto. For example, the touch electrode TE' may also be formed through various methods known to those skilled in the art.

A portion of the touch electrode TE' may be formed as the recess TEC' received in the through hole TH. Another portion of the touch electrode TE' may be formed as a non-recess NTEC' that is not received in the through hole TH. The uppermost surface x of the recess TEC' positioned at the lowest position may be positioned at a position lower than the uppermost surface y of the non-recess NTEC'. For example, at least a portion of the recess TEC' may be positioned at a position lower than the uppermost surface y of the non-recess NTEC'. As described with reference to FIG. 8, the recess TEC' may include the first recess TEC1' and the second recess TEC2' having different widths in a plan view. For example, the first recess TEC1' and the second recess TEC2' shown in FIG. 15D may be configured similarly to the first recesses TEC1 and TEC1' and the second recesses TEC2 and TEC2' shown in FIGS. 8 and 12.

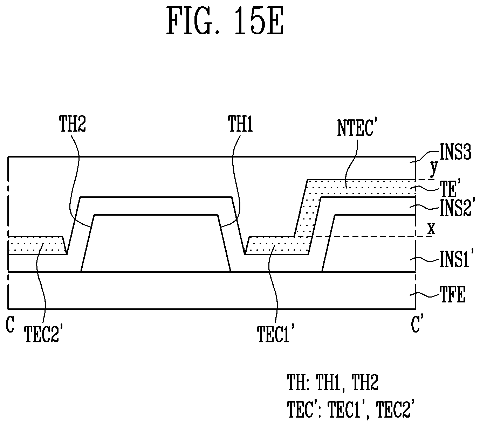

Referring to FIG. 15E, the third insulating layer INS3 may be formed on the second insulating layer INS2' and the touch electrode TE'. The third insulating layer INS3 may be formed through substantially the same process as the first insulating layer INS1' described with reference to FIG. 15A.

As described above, according to the method of manufacturing the display device shown in FIGS. 15A to 15E, at least a portion of the recess TEC' may be positioned lower than the uppermost surface y of the non-recess NTEC'. As a result, as described with reference to FIG. 12, the viewing angle of the display device DD may be widened, and the color shift phenomenon may be reduced as the light amount received by the user increases.

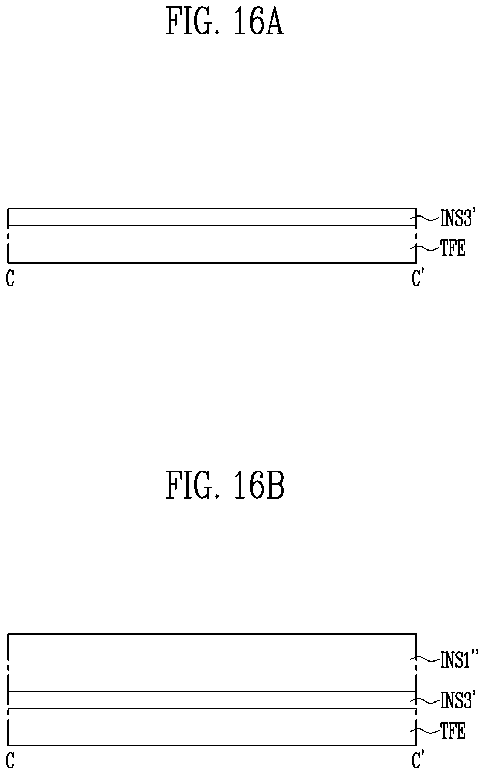

FIGS. 16A to 16E are cross-sectional views illustrating a method of manufacturing the touch sensing unit shown in FIG. 13.

Referring to FIG. 16A, the third insulating layer INS3' may be formed on the thin film encapsulation layer TFE. The third insulating layer INS3' may be an inorganic insulating layer including an inorganic material. For example, the third insulating layer INS3' may include silicon nitride (SiNx), silicon oxide (SiOx), silicon oxynitride (SiOxNy), and/or metal oxides such as aluminum oxide (AlOx). However, a material of the third insulating layer INS3' is not necessarily limited thereto. For example, the third insulating layer INS3' may include an organic insulating layer including an organic material.

According to an embodiment of the present disclosure, the third insulating layer INS3' may be formed using an atomic layer deposition (ALD) method, a sol-gel process, a chemical deposition method (for example, plasma enhanced chemical vapor deposition (PECVD), or the like, but this is merely an example, and is not necessarily limited thereto. For example, the third insulating layer INS3' may be formed through various methods known to those skilled in the art.

Referring to FIG. 16B, the first insulating layer INS1" may be formed on the third insulating layer INS3'. The first insulating layer INS1" may be an organic insulating layer including an organic material. The organic insulating layer may include, for example, acrylic resin, epoxy resin, phenolic resin, polyamide resin, polyimide resin, unsaturated polyester resin, poly-phenylene ether resin, poly-phenylene sulfide resin, and/or benzocyclobutene resin. However, a material of the first insulating layer INS1" is not necessarily limited thereto. For example, the first insulating layer INS1" may include an inorganic insulating layer including an inorganic material.

The first insulating layer INS1" may be formed through a thermal deposition process. The thermal deposition process for forming the first insulating layer INS1" may be performed in a temperature range that does not damage the light emitting element LD described with reference to FIG. 5. However, embodiments are not necessarily limited thereto. For example, the first insulating layer INS1" may be formed through various methods known to those skilled in the art.

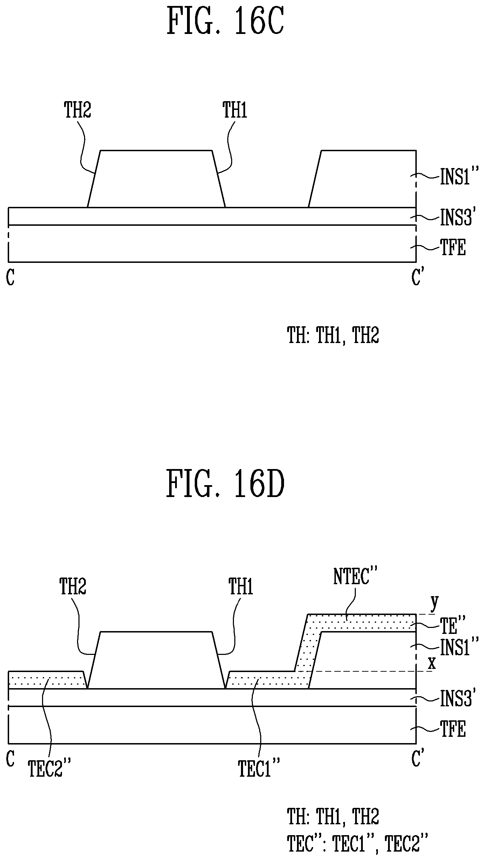

Referring to FIG. 16C, a portion of the first insulating layer INS1" may be removed to form the through hole TH exposing a portion of an upper surface of the third insulating layer INS3. The through hole TH may be formed through a photolithography process such as exposure and development. The through hole TH may include the first through hole TH1 and the second through hole TH2 having different widths, as described with reference to FIG. 13. For example, the first through hole TH1 and the second through hole TH2 shown in FIG. 16C may be configured similarly to the (2_1)-th through hole TH2_1 and the (2_2)-th through hole TH2_2 shown in FIG. 13, respectively.

Referring to FIG. 16D, the touch electrode TE" may be formed on the first insulating layer INS1"and a portion of an upper surface of the third insulating layer INS3' exposed by the through hole TH. The touch electrode TE" may be formed through physical vapor deposition (PVD) such as sputtering, chemical vapor deposition (CVD), or the like, but is not necessarily limited thereto. For example, the touch electrode TE" may also be formed through various methods known to those skilled in the art.

A portion of the touch electrode TE" may be formed as the recess TEC" received in the through hole TH. Another portion of the touch electrode TE may be formed as the non-recess NTEC" that is not received in the through hole TH. The uppermost surface x of the recess TEC" positioned at the lowest position may be positioned lower than the uppermost surface y of the non-recess NTEC". For example, at least a portion of the recess TEC" may be positioned at a position lower than the uppermost surface y of the non-recess NTEC". As described with reference to FIG. 8, the recess TEC" may include the first recess TEC1" and the second recess TEC2" having different widths in a plan view. For example, the first recess TEC1" and the second recess TEC2" shown in FIG. 16D may be configured similarly to the first recesses TEC1 and TEC1" and the second recesses TEC2 and TEC2" shown in FIGS. 8 and 13.

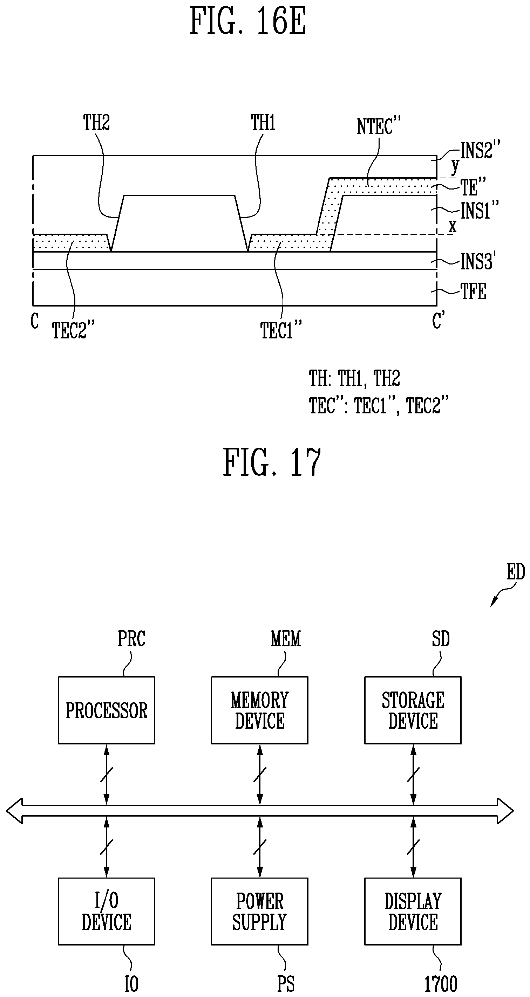

Referring to FIG. 16E, the second insulating layer INS2" may be formed on the first insulating layer INS1" and the touch electrode TE". The second insulating layer INS2" may be formed through substantially the same process as the first insulating layer INS1" described with reference to FIG. 16B.

As described above, according to the method of manufacturing the display device shown in FIGS. 16A to 16E, at least a portion of the recess TEC" may be positioned lower than the uppermost surface y of the non-recess NTEC". As a result, as described with reference to FIG. 13, the viewing angle of the display device DD may be widened, and the color shift phenomenon may be reduced as the light amount recognized by the user increases.

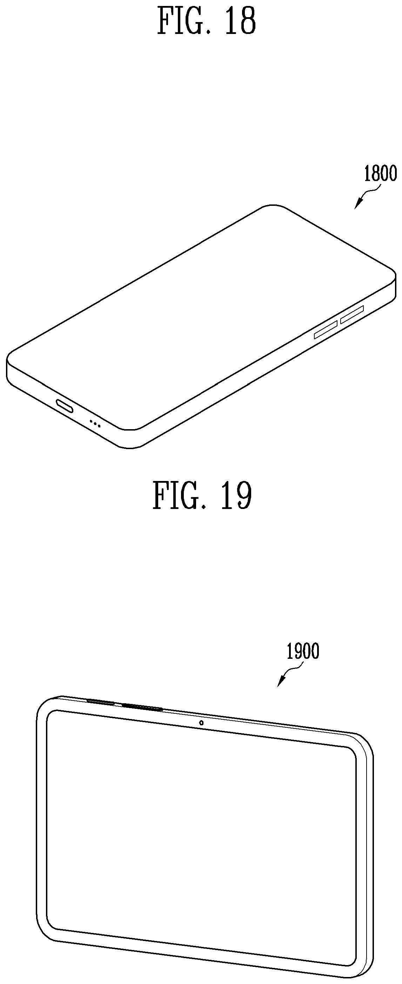

FIG. 17 is a block diagram illustrating an electronic device including a display device according to embodiments of the present disclosure. FIG. 18 is a perspective view illustrating an example in which the electronic device 17 is implemented as a smartphone. FIG. 19 is a perspective view illustrating an example in which the electronic device of FIG. 17 is implemented as a tablet computer.

Referring to FIGS. 17 to 19, the electronic device ED may include a processor PRC, a memory device MEM, a storage device SD, an input/output device IO, a power supply PS, and a display device 1700. At this time, the display device 1700 may be the display device DD of FIG. 1. In addition, the electronic device ED may further include several ports capable of communicating with a video card, a sound card, a memory card, a universal serial bus (USB) device or the like, or communicating with other systems. In an embodiment of the present disclosure, as shown in FIG. 18, the electronic device ED may be implemented as a smartphone 1800. In an embodiment of the present disclosure, as shown in FIG. 19, the electronic device ED may be implemented as a tablet computer 1900. However, this is an example, and the electronic device ED is not necessarily limited thereto. For example, the electronic device ED may be implemented as a mobile phone, a video phone, a smart pad, a smart watch, a car navigation system, a computer monitor, a notebook computer, and a head mounted display device.

The processor PRC may perform specific calculations or tasks for providing input image data to the display device 1700. According to an embodiment of the present disclosure, the processor PRC may be a microprocessor, a central processing unit, an application processor, or the like. The processor PRC may be connected to other components through an address bus, a control bus, and a data bus. According to an embodiment of the present disclosure, the processor PRC may also be connected to an expansion bus such as a peripheral component interconnect (PCI) bus.

The memory device MEM may store data necessary for an operation of the electronic device ED. For example, the memory device MEM may include a non-volatile memory device such as an erasable programmable read-only memory (EPROM) device, an electrically erasable programmable read-only memory (EEPROM) device, a flash memory device, a phase change random access memory (PRAM) device, a resistance random access memory (RRAM) device, a nano floating gate memory (NFGM) device, a polymer random access memory (PoRAM) device, a magnetic random access memory (MRAM), a ferroelectric random access memory (FRAM) device, and/or a volatile memory device such as a dynamic random access memory (DRAM) device, a static random access memory (SRAM) device, a mobile DRAM device.

The storage device SD may include a solid state drive (SSD), a hard disk drive (HDD), a compact disc read only memory (CD-ROM), and the like.

The input/output device IO may include input means such as a keyboard, a keypad, a touchpad, a touch screen, and a mouse, and output means such as a speaker and a printer. According to an embodiment of the present disclosure, the display device 1700 may be included in the input/output device IO.

The power supply PS may supply power necessary for the operation of the electronic device ED. For example, the power supply PS may be a power management integrated circuit (PMIC).

The display device 1700 may display an image corresponding to visual information of the electronic device ED based on the input image data provided from the processor PRC. At this time, the display device 1700 may be an organic light emitting display device or a quantum dot light emitting display device, but is not necessarily limited thereto. The display device 1700 may be connected to other components through buses or another communication link.

Referring to FIG. 18, reliability of driving of a smartphone 1800 including a display device according to embodiments of the disclosure may be increased.

Referring to FIG. 19, reliability of driving of a tablet PC 1900 including a display device according to embodiments of the disclosure may be increased.

Although specific embodiments and applications are described herein, other embodiments and variations may be derived from the above description. Therefore, the disclosure is not necessarily limited to these embodiments, and extends to the scope of the present disclosure as well as various obvious modifications, and equivalents thereof.

## Claims

1. A display device (DD), comprising:
a display panel (DP) including a plurality of sub-pixels (SPX) having emission areas (EMA); and
a touch electrode (TE) disposed on the display panel (DP) and overlapping a non-emission area (NEMA) adjacent to the emission areas (EMA),
wherein the touch electrode (TE) includes a first recess (TEC1) that is recessed in a direction (D3) facing the display panel (DP) and overlapping a portion of the non-emission area (NEMA) disposed between first and second emission areas (EMA1, EMA2) that are adjacent to each other among the emission areas (EMA).

2. The display device (DD) according to claim 1, wherein the plurality of sub-pixels (SPX) comprises:
a first sub-pixel (SPX1) including the first emission area (EMA1);
a second sub-pixel (SPX2) including the second emission area (EMA2); and
a third sub-pixel (SPX3) including a third emission area (EMA3) that is adjacent to at least one of the first and second emission areas (EMA1, EMA2),
wherein the second emission area (EMA2) is greater in size than the first emission area (EMA1), and
wherein the third emission area (EMA3) is greater in size than the second emission area (EMA2).

3. The display device (DD) according to claim 2, wherein the plurality of sub-pixels (SPX) further includes a fourth sub-pixel including a fourth emission area that is adjacent to the second emission area (EMA2) among the emission areas,
wherein the second emission area (EMA2) is disposed between the first emission area (EMA1) and the fourth emission area,
wherein the fourth emission area has substantially the same size as the first emission area (EMA1), and
wherein the touch electrode (TE) further includes a second recess (TEC2) overlapping another portion of the non-emission area (NEMA) disposed between the second emission area (EMA2) and the fourth emission area.

4. The display device (DD) according to claim 3, wherein the first emission area (EMA1), the second emission area (EMA2), and the fourth emission area are sequentially arranged in a first direction (DR1), and
wherein a width (W1) of the first recess (TEC1) in a second direction (DR2) crossing the first direction (DR1) is different from a width (W2) of the second recess (TEC2) in the second direction (DR2).

5. The display device (DD) according to any of the preceding claims 1 to 4, further comprising:
a first insulating layer (INS1) disposed between the display panel (DP) and the touch electrode (TE),
wherein the first insulating layer (INS1) includes a trench (TR1) that is recessed in the direction (DR3) facing the display panel (DP), and
wherein the first recess (TEC1) is disposed on the trench (TR1).

6. The display device (DD) according to claim 5, wherein the first insulating layer (INS1) includes an organic material.

7. The display device (DD) according to any of the preceding claims 5 to 6, wherein the touch electrode (TE) is formed by chemical vapor deposition, CVD, on the first insulating layer (INS1).

8. The display device (DD) according to any of the preceding claims 5 to 7, wherein the trench (TR1) is formed by removing a portion of the first insulating layer (INS1) using a photolithography method.

9. The display device (DD) according to any of the preceding claims 5 to 8, wherein a depth (T2) of the trench (TR1) is less than a thickness (T1) of the first insulating layer (INS1).

10. The display device (DD) according to claim 9, wherein a thickness (T3) of the touch electrode (TE) is less than the depth (T2) of the trench (TR1).

11. The display device (DD) according to any of the preceding claims 1 to 8, further comprising:
a first insulating layer (INS1') disposed between the display panel (DP) and the touch electrode (TE),
wherein the first insulating layer (INS1') includes a first through hole (TH1_1) overlapping the first recess (TEC1'), and
wherein at least a portion of the first recess (TEC1') is disposed in the first through hole (TH1_1).

12. The display device (DD) according to claim 11, further comprising:
a second insulating layer (INS2') disposed on a portion of an upper surface of the display panel (DP) exposed by the first through hole (TH1_1) and the first insulating layer (INS1').

13. The display device (DD) according to claim 12, wherein a portion of the first recess (TEC1') is disposed on a portion of the second insulating layer (INS2') overlapping the first through hole (TH1_1).

14. The display device (DD) according to claim 11, further comprising:
a third insulating layer (INS3') disposed between the display panel (DP) and the first insulating layer (INS1"),
wherein the first through hole (TH2_1) exposes a portion of the third insulating layer (INS3'), and
wherein a portion of the first recess (TEC1") is disposed on the portion of the third insulating layer (INS3') exposed by the first through hole (TH2_1).

15. The display device (DD) according to claim 14, wherein the portion of the first recess (TEC") is lower than an uppermost surface (z) of the first insulating layer (INS1") disposed on the third insulating layer (INS3').
